# EUROPEAN PATENT SPECIFICATION

(11) **EP 1 659 415 B1**
(45) Date of publication and mention of the grant of the patent: **24.07.2019**
(21) Application number: 05110798.5
(22) Date of filing: 16.11.2005
(51) Int. Cl.: G01R 31/28, G01R 31/40, H02J 9/06

(54) **Integrity testing of isolation means in an uninterruptible power supply**
Integritätstest der Isolierungsmittel in einer unterbrechungsfreien Stromversorgung
Essai d'intégrité d'un moyen d'isolation dans une alimentation électrique sans interruption

(30) Priority: 22.11.2004 EP 04405721
(43) Date of publication of application: 24.05.2006
(73) Proprietor: Inventio AG, 6052 Hergiswil (CH)
(72) Inventor: Grundmann, Steffen, 8906 Bonstetten (CH); Gremaud, Nicolas, 8820 Wädenswil (CH)

(56) References cited:
- EP-A- 0 309 124
- JP-A- 2000 014 155
- US-A- 5 325 062
- US-A- 5 548 463
- US-A- 6 157 308
- US-A1- 2004 039 536
- US-B1- 6 259 234
- US-B1- 6 342 791
- US-B2- 6 628 012
- HUNTER P L ET AL: "Fault tolerant hot-pluggable power system design" 13 February 1994 (1994-02-13), APPLIED POWER ELECTRONICS CONFERENCE AND EXPOSITION, 1994. APEC '94. CONFERENCE PROCEEDINGS 1994., NINTH ANNUAL ORLANDO, FL, USA 13-17 FEB. 1994, NEW YORK, NY, USA,IEEE, PAGE(S) 815-822 , XP010118486 ISBN: 0-7803-1456-5 * page 820, column 1 *

## Description

The present invention relates to uninterruptible power supplies and in particular to an apparatus and a method for testing the integrity of isolation means used in an uninterruptible power supply to isolate an auxiliary power source from a main power supply during a disruption of the main power supply.

An uninterruptible power supply (herein referred to as a UPS) can be used to guarantee the power supply to an electrical load for a limited period in the event of a disruption to the dedicated mains electricity supply. A UPS is generally provided with an input for the mains electricity supply, an output for connection to the electrical load, a rechargeable energy storage unit, such as a battery, interconnected with the output, and a switch located between the input and the interconnected energy storage unit / output network, and a sensor detecting any disruption to the electricity supply at the input. In normal operation (e.g. non-disruption of mains power), the switch is closed and permits energy to flow from the input to the energy storage unit and the output. In emergency operation (e.g. mains power failure), the sensor detects the disruption to the electricity supply at the input and activates the switch to isolate the energy storage unit / output network from the input. Accordingly the power supply to the electrical load is maintained by the energy storage unit.

Such a UPS is described in Japanese Patent Unexamined Publication No. 04-147076 which also includes a backup-battery check circuit to detect a failure of the rechargeable battery (energy storage unit).

It is vitally important during emergency operation that the energy storage unit is always isolated from the disrupted mains electricity network since otherwise it would rapidly discharge the vast majority of its stored energy back into the mains network and thus would be incapable of maintaining the power supply to the electrical load for any appreciable length of time.

In most instances, the isolation capability of the switch is only ever tested during actual real-life situations when the UPS is called upon to switch from normal operation to emergency operation. Obviously, if the switch fails to isolate the energy storage unit from the input in these circumstances there could be catastrophic consequences when the power supply to the electrical load unexpectedly plummets and eventually fails.

A UPS is described in EP-A-0309124 which during emergency operation detects whether an electronic isolation switch has failed, and if so, operates a mechanical isolation backup switch to isolate the entire UPS circuit from the commercial AC input. However, this purely reactive procedure is only brought into effect during emergency operation when the commercial AC power supply has already been disrupted. As such it requires the additional mechanical isolation backup switch to ensure that power is prevented from flowing from the battery into the disrupted commercial AC power supply.

The objective of the invention is to overcome these problems by providing an uninterruptible power supply wherein the isolation means is proactively and automatically tested during normal operation to ensure that it is capable of effectively isolating the input from the output and energy storage unit during emergency operation.

This objective is achieved by providing an uninterruptible power supply comprising an input for coupling to a main power supply, an output for connection to an electrical load, an auxiliary power supply, and selective isolation means configured to isolate the auxiliary power supply from the input during emergency operation characterised in further comprising first means establishing a reverse polarity across the isolation means for a test period during normal operation and second means monitoring a voltage proportional to an input voltage to the isolation means and outputting an error signal if the monitored voltage remains or rises above a first reference value during the test period.

The invention also provides a method for testing selective isolation means used in an uninterruptible power supply to isolate an auxiliary power supply from an input during emergency operation, characterised by establishing a reverse polarity across the isolation means for a test period during normal operation, monitoring a voltage proportional to an input voltage to the isolation means, and outputting an error signal if the monitored voltage remains or rises above a first reference value during the test period.

The error signal provides an indication that the isolation means is faulty and accordingly corrective action can be taken. In reversing the polarity of the isolation means during the test period, either a) an input voltage to the isolation means is reduced below that of its output or b) the output voltage is increased above that at the input. In either case, if the isolation means is faulty, there will be a reverse current flow therethrough.

Preferably the isolation means is a diode, since a diode will automatically reverse bias and thereby assume its isolation state when its polarity is reversed. A skilled person will readily appreciate that the diode may be replaced by two diodes in series to increase the admissible reverse voltage or by two diodes in parallel to increase the admissible forward current.

Alternatively the isolation means could be a switch. In this case, a third means is required to trigger the switch into its non-conducting state during the test period.

Preferably the auxiliary power supply is a rechargeable energy storage unit and a comparator can be used to compare a voltage at the output of the uninterruptible power supply with a second reference value and to output a test commence signal if the output voltage is greater than the second reference value. This comparator provides an excellent indication of the level to which the energy storage unit has been charged and only permits the test to commence when the energy storage unit has been sufficiently charged. Alternatively, if the test cycle is sufficiently long, the user can rely on the fact that the time period between initial power up and the first test is sufficiently large to ensure that the energy storage unit has been sufficiently charged.

Although batteries or conventional capacitor banks can be used in the uninterruptible power supply, in the preferred embodiments of the invention the rechargeable energy source is one or more supercapacitors.

In a preferred application of the present invention, the uninterruptible power supply includes an AC/DC converter at its input and is incorporated in an elevator between an AC mains power supply and a brake module and controller mounted on an elevator car.

The invention is herein described by way of specific examples with reference to the accompanying drawings of which:
Figure 1 is a general overview of a typical application for a UPS according to the present invention;
Figure 2 is a circuit diagram of a UPS according to a first embodiment of the invention;
Figures 3a - 3f are graphical representations of voltage profiles at various nodes of the circuit illustrated in Fig. 2;
Figure 4 shows an alternative isolation means to the diode of Fig. 2;
Figure 5 shows an alternative arrangement to reduce the voltage at the diode input;
Figure 6 is circuit diagram incorporating means to increase the voltage at the diode output and an alternative means of monitoring the diode input voltage: and
Figures 7a - 7c are graphical representations of voltage profiles at various nodes of the circuit illustrated in Fig. 6.

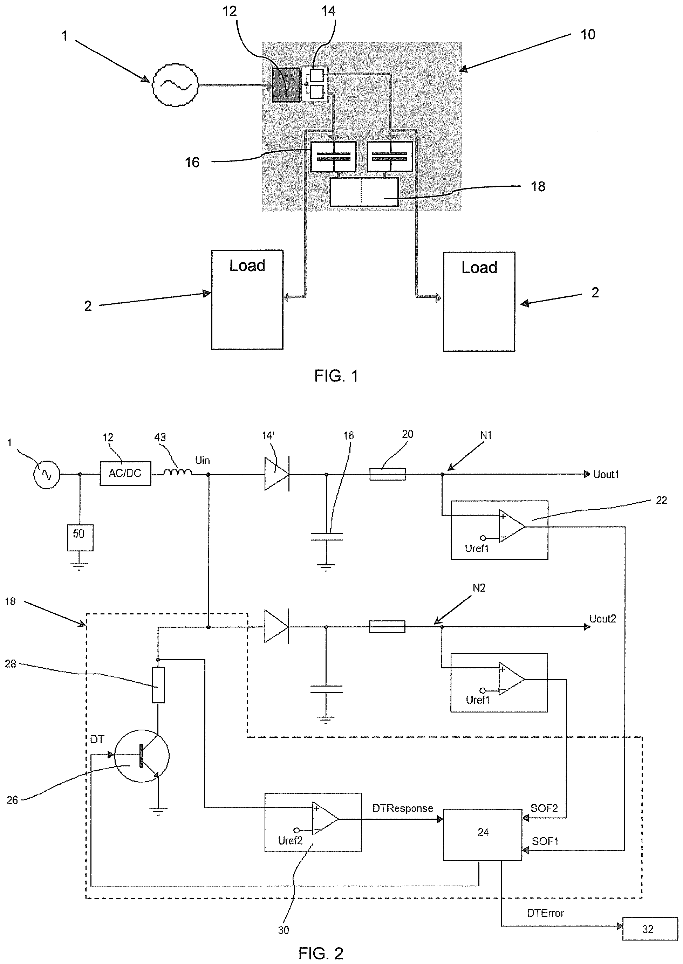

Fig. 1 shows a typical application for a UPS 10. In this instance the UPS 10 interconnects a mains power supply 1 with two electromagnetic brake modules 2 mounted on an elevator car within a hoistway of an elevator installation. Each module 2 is activated by an integral brake controller to frictionally engage with a guide rail in the hoistway thereby bringing the elevator car to a stop. As safe operation of the elevator clearly depends on the reliability of the power supply to the brake modules 2 and associated brake controllers, the UPS 10 is installed to guarantee this power supply. As shown, the UPS 10 contains an AC/DC converter 12, isolation means 14, two rechargeable energy storage units 16 (one per brake module 2) and one or two testers 18 to check the integrity of the isolation means 14.

A specific embodiment of the invention is shown in detail in the circuit diagram of Fig. 2. The AC/DC converter 12 transforms the standard AC voltage (220V, 50Hz) from the mains power supply 1 into a DC input voltage Uᵢₙ (48V) for the UPS 10. A surge protection circuit 50 protects the AC/DC converter 12 and thus the whole energy supply system against the dangerous effects of overvoltage surges in the AC mains. Furthermore, the converter 12 is current limited to 5A to protect it in the event of a short circuit. The DC input voltage Uᵢₙ delivered by the AC/DC converter 12 is passed through a choke 43 and split into two independent yet identical networks N1 and N2 each supplying a DC output voltage Uₒᵤₜ which is feed to the respective brake module 2 and associated controller. Each of these DC power networks N1 and N2 is provided with a serially connected diode 14' and fuse 20 as well as a rechargeable supercapacitor 16 connected in parallel. In the present embodiment the diodes 14' function as the isolation means 14. They are forward biased to permit current flow from the AC/DC converter 12 to the respective supercapacitor 16 and brake module 2, and reverse biased for current flow in the opposite direction. Accordingly, during normal operation, current flows from the mains power supply 1 through the AC/DC converter 12 and the diodes 14' to charge the supercapacitors 16 and power the brake modules 2. If there is a disruption to the mains power supply 1 causing the DC input voltage Uᵢₙ supplied by the AC/DC converter 12 to drop, the diodes 14' will automatically reverse bias and thereby prevent backflow of energy from the supercapacitors 16 into the disrupted mains power supply 1. In these circumstances, the energy stored in the supercapacitors 16 is used exclusively to maintain an effective power supply to the brake modules 2.

If the diodes 14' are overloaded then they can be subjected to degradation and electrostatic breakdown causing them to freely conduct in both directions. In these circumstances the diodes 14' would not be capable of isolating the supercapacitors 16 from a disrupted power supply 1. The following describes a test used to verify the integrity and specifically the isolation capability of the diodes 14' during normal operation of the UPS 10.

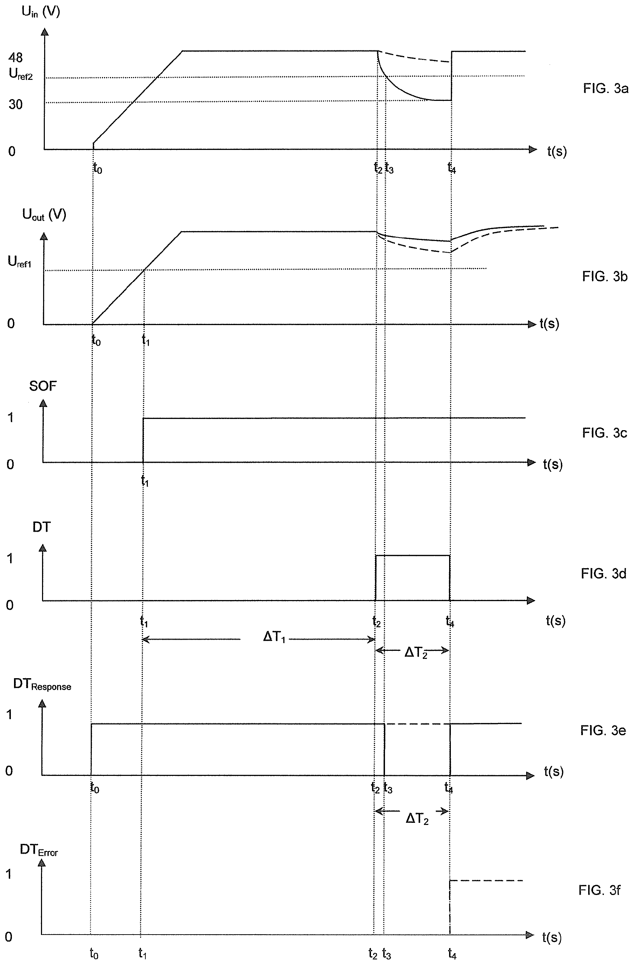

The DC output voltage Uₒᵤₜ of each network N1 and N2 is continually monitored by a first comparator 22. Initially, the supercapacitors 16 will be completely discharged, so when the UPS 10 is connected to the mains power supply 1 for the first time, the supercapacitors 16 will begin to charge and the output voltage Uₒᵤₜ on the DC networks N1 and N2 will grow linearly due to the current limitation of the AC/DC converter 12 (as shown in Fig. 3b). When the output voltage Uₒᵤₜ reaches a first reference value U_{ref1}, a signal SOF from the comparators 22 change state to confirm that the supercapacitors 16 have charged to a level above the first reference voltage U_{ref1}.

During normal operation, the integrity of the diodes 14' is periodically checked by a tester 18 which will verify whether either of the diodes 14' has broken down to permit current conduction in both directions. The tester 18 includes a test controller 24 receiving the signals SOF from the first comparators 22, a serial network of a resistor 28 and a transistor 26 connected between the output from the choke 43 and earth, and a second comparator 30 also connected to the output from the choke 43 to monitor the DC input voltage Uᵢₙ. The test controller 24 can be connected directly, or indirectly over the brake controller, to an elevator controller 32.

The function of the UPS 10 and specifically that of the tester 18 is described with reference to Figs. 3a-3f, which show in simplified and exaggerated form voltage profiles at various nodes of the circuit illustrated in Fig. 2. The UPS 10 is initially connected to the mains power supply 1 at a time t₀. The DC voltage input Uᵢₙ delivered by the converter 12 rises linearly to the rated voltage as shown in Fig. 3a. Current flows from the converter 12 through the diodes 14' to charge the supercapacitors 16 and the DC output voltages Uₒᵤₜ rise linearly as shown in Fig. 3b. When the DC output voltages Uₒᵤₜ reach the first reference voltage level U_{ref1} at a time t₁ the signals SOF from both of the first comparators 22 become active as shown in Fig. 3c and these active signals SOF instruct the test controller 24 that the test can commence.

As shown in Fig. 3d, during a first period ΔT₁ of the test cycle, a test signal DT from the test controller 24 to a gate of the transistor 26 remains inactive and thereby there is no conduction of current through the resistor 28 and transistor 26. However, at a time t₂ a second period ΔT₂ of the test cycle commences and the test signal DT becomes active to cause saturation of the transistor 26. Accordingly, current flows directly from the converter 12 through the choke 43, the resistor 28 and the transistor 26 to earth. The resistor 28 has a resistance value of 6Ω and since the converter 12 is current limited to 5A it is clearly unable to maintain the DC input voltage Uᵢₙ at the rated value. The choke 43 effectively limits the rate of change of the current flowing from the converter 12 and therefore the DC input voltage Uᵢₙ immediately collapses.

At the onset of this collapse in the DC input voltage Uᵢₙ, the diodes 14' should automatically reverse bias and therefore isolate the charged supercapacitors 16 from the converter 12, the resistor 28 and the transistor 26. In this case the DC input voltage Uᵢₙ will rapidly decay as shown by the solid line in Fig. 3a. Once the DC input voltage Uᵢₙ drops past the second reference voltage U_{ref2} at a time t₃, a signal DT_{Response} from the second comparator 30 changes from an active to an inactive state as illustrated by the solid line in Fig. 3e.

If, on the other hand, the diodes 14' are faulty for some reason and they permit conduction in both directions, at the onset of the collapse of the DC input voltage Uᵢₙ, the supercapacitors 16 will, in addition to providing the DC output voltage Uₒᵤₜ, discharge through the diodes 14' to try to maintain the DC input voltage Uᵢₙ at its rated level. Hence, although there will be some decay in the DC input voltage Uᵢₙ as shown by the dashed line in Fig. 3a, this decay will not be as rapid as in the case where the diodes 14 are faultless. In these circumstances, the DC input voltage Uᵢₙ does not drop past the second reference voltage U_{ref2} during the second period ΔT₂ of the test cycle and therefore the signal DT_{Response} from the second comparator 30 will remain in the active state illustrated by the dashed line in Fig. 3e.

The test controller 24 monitors the signal DT_{Response} from the second comparator 30 during the second period ΔT₂ of the test cycle. If there is a state transition in the signal DT_{Response} from an active to an inactive state during this period ΔT₂, then the controller 24 recognises that the diodes 14' are healthy. On the contrary, if the signal DT_{Response} remains active throughout this period ΔT₂, then the controller 24 outputs an error signal DT_{Error} to the elevator controller 32 signalling that one or both of the diodes 14' are faulty. The controller 24 may include a memory for storing the fault information gathered during the test pulse duration ΔT₂ for a more convenient information transfer to the elevator controller 32 at a later time. On receipt of this error signal DT_{Error}, the elevator controller 32 moves the car to the nearest landing, opens the doors to allow any passengers to exit and activates the electromechanical brake modules 2 to park the car in that position. The error signal DT_{Error}, once established, can only be reset and the elevator restarted after the faults diode or diodes 14' have been replaced.

The entire test cycle repeats itself after time t₄. In order to ensure that the test itself does not damage the diodes 14', the second period ΔT₂ is generally as short as possible, typically in the region of 10µs. The first period ΔT₁ of the test cycle can be adjusted by the user to vary the frequency of the test; in some applications, the user may want to automatically test the diodes once per hour, while in other applications a test frequency of once per week may suffice.

In order to enhance the collapse in the DC input voltage Uᵢₙ, a capacitor can be connected in parallel across the resistor 28.

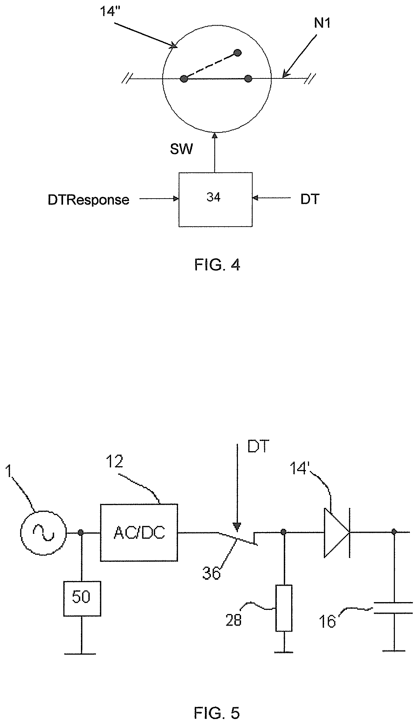

It will be readily understood that the diodes 14' of the previously described embodiment are only one type of isolation means 14 which can be used in the UPS 10. In a second embodiment of the invention each of the diodes 14' in the circuit of Fig. 2 is substituted by a switch 14" as shown in Fig. 4. The switch 14" can be electromechanical or, preferably, a semiconductor switch such as a transistor. If an electromechanical switch 14" is used heavy loads therethrough coupled with long periods in the conducting state can cause the contacts of the switch 14" to become sticky and in an extreme example will cause the contacts to fuse permanently in the conducting state. Accordingly, in these circumstances the switch 14" will not be able to break the DC network N1 during a power disruption. If a semiconductor switch 14" is used then it is subject to the same degradation and electrostatic breakdown problems of the diodes 14' of the previous embodiment.

Whereas the diodes 14' of the previous embodiment are predisposed to conduct in one direction of current flow and isolate in the opposing direction, a signal SW must be supplied to the switch 14" to selectively make or break the DC network N1. The signal SW must cause the switch 14" to break the DC network N1 during a disruption in the mains power supply 1 as well as during the second time period ΔT₂ of the test cycle.

Since the second comparator 30 already monitors the DC input voltage Uᵢₙ for the tester 18', the output DT_{Response} from the second comparator 30 is also used in the present invention as an input to the switch controller 34 so as to avoid unnecessary duplication of components in the circuit. The signal DT from the test controller 24 is also fed into the switch controller 34.

The function of the switch controller 34 is illustrated in Table 1, wherein logic 1 refers to the switch 14" making the DC network N1 and logic 0 refers to the switch 14" breaking the DC network N1.

**Table 1**

| DT | DT_{Response} | SW |
|---|---|---|
| 0 | 0 | 0 |
| 0 | 1 | 1 |
| 1 | 0 | 0 |
| 1 | 1 | 0 |

During normal operation, current flows from the mains power supply 1 through the AC/DC converter 12 and the switches 14" to charge the supercapacitors 16 and power the brake modules 2. If there is a disruption to the mains power supply 1 causing the DC input voltage Uᵢₙ supplied by the AC/DC converter 12 to drop below the second reference voltage U_{ref2}, then the signal DT_{Response} from the second comparator 30 becomes inactive thereby causing the switch 14" to break the network N1 and preventing backflow of energy from the supercapacitors 16 into the disrupted mains power supply 1.

As in the previous embodiment, when the DC output voltages Uₒᵤₜ reach the first reference voltage level U_{ref1} at a time t₁ the signals SOF from the first comparators 22 become active as shown in Fig. 3c and these active signals SOF instruct the test controller 24 that the test can commence. The test follows the same procedure already described with reference to Figs. 3a to 3f.

During the second period ΔT₂ of the test cycle, the signal DT from the test controller 24 is active and holds the switch 14" in a non-conducting state while the test controller 24 monitors the signal DT_{Response} from the second comparator 30. If there is a state transition in the signal DT_{Response} from an active to an inactive state during this period ΔT₂, then the controller 24 recognises that the switches 14" are healthy. On the contrary, if the signal DT_{Response} remains active throughout this period ΔT₂ (as shown by the dashed line in Fig. 3e), then the controller 24 outputs an error signal DT_{Error} to the elevator controller 32 signalling that one or both of the switches 14" are faulty.

It will be appreciated that the main components of the tester 18 are a) the serial network of the resistor 28 and the transistor 26 which establishes a reverse polarity across the diode 14' or switch 14" during the second period ΔT₂ of the test cycle, b) the second comparator 30 which monitors the DC input voltage Uᵢₙ during the second period ΔT₂ of the test cycle and c) the test controller 24 to trigger the transistor 26 and evaluate the response signal DT_{Response} from the second comparator 30.

Fig. 5 illustrates an alternative embodiment of the present invention wherein the transistor 26 used in the previous embodiments to reverse the polarity of the diode 14' by draining the DC input voltage Uᵢₙ during the second period ΔT₂ is replaced by a test switch 36 located between the mains power supply 1 and the diodes 14' to completely isolate the DC networks N1 and N2 from the mains power supply 1 during this period ΔT₂. Accordingly, the voltage profiles will be similar to those of Figs. 3a to 3f during operation, the only difference being that the DC input voltage Uᵢₙ will drain through the resistor 28 towards zero instead of 30V during the second time period ΔT₂ if the diodes 14' are healthy. Otherwise, the test procedure is the same as previously described. Although in this particular embodiment the test switch 36 is placed between the AC/DC converter 12 and the diodes 14', it will be appreciated that the switch 36 can be located between the mains power supply 1 and the AC/DC converter 12.

Although not shown, it will be appreciated, that a further alternative to reduce of the DC input voltage Uᵢₙ during the second period ΔT₂ of the test cycle would be to arrange a primary winding of a transformer between the AC/DC converter and the diode and a drain circuit comprising a secondary winding of the transformer, a resistor and a transistor serially arranged between the AC/DC converter and earth. Saturation of the transistor during the second period ΔT₂ of the test cycle will cause a transient current to flow through the secondary winding in turn inducing an emf in the primary winding causing the voltage at the input of the diode to decay.

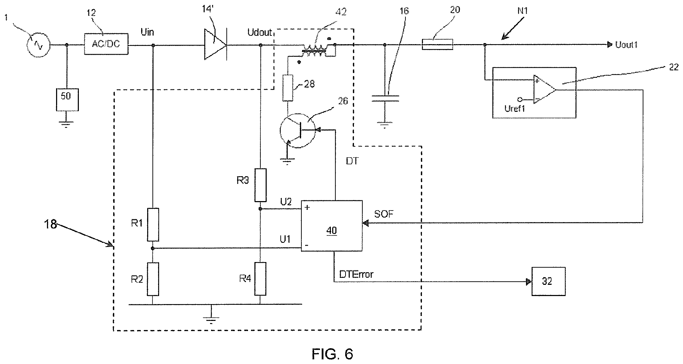

Fig. 6 shows not only an alternative way in which to establish the reverse polarity across the diodes 14' but also an alternative means of monitoring the DC input voltage Uᵢₙ during the second period ΔT₂ of the test cycle.

Instead of draining the DC input voltage Uᵢₙ to the diode 14', a transformer 42 is used to increase the DC output voltage U_{dout} from the diode 14' during the second period ΔT₂ of the test. A primary winding of the transformer 42 is connected between the diode 14' and the supercapacitor 16 and a secondary winding of the transformer 42 is connected in series with a resistor 28 and a transistor 26 between the supercapacitor 16 and earth.

A series network of two resistors R1 and R2 is connected between the input to the diode 14' and earth. The combined resistance of which is relatively large to prevent the resistive network from draining the power supply. A first voltage U₁ at the junction of the two resistors R1 and R2, which is proportional to the input voltage Uᵢₙ to the diode 14', is fed into a test controller 40. Similarly, a resistive network R3 and R4 is connected to the output of the diode 14' and second junction voltage U₂, which is proportional to the output voltage U_{dout} from the diode 14', is fed into the controller 40. The values of the resistors R1, R2, R3 and R4 are selected so that the first junction voltage U₁ is equal to the second junction voltage U₂ only when the DC output voltage U_{dout} exceeds the DC input voltage Uᵢₙ by a specific voltage difference U_{dif}.

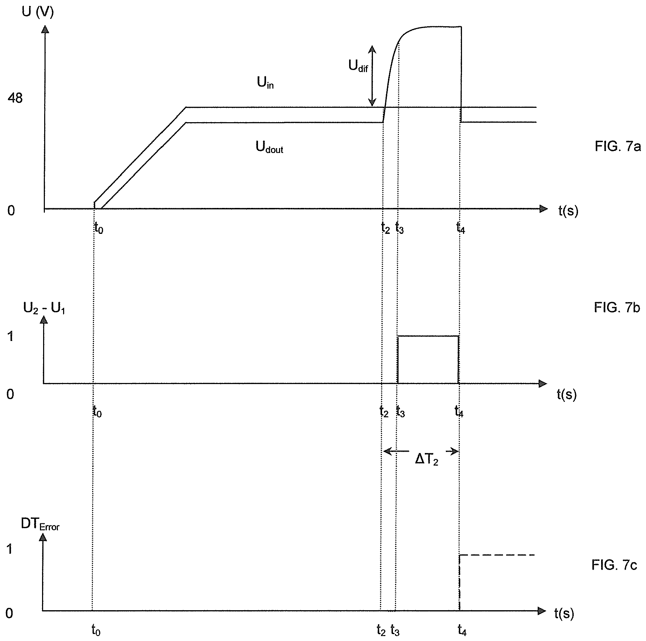

During the second period ΔT₂, the test signal DT from the controller 40 causes the transistor 26 to saturate and thereby current flows through a secondary winding of the transformer 42, the resistor 28 and the transistor 26. This transient current flow induces an emf in a primary winding of the transformer 43 causing the voltage U_{dout} at the output of the diode 14' to increase to a value greater than the input voltage Uᵢₙ and hence the diode 14' is reverse biased. This effect is shown in exaggerated form in Fig. 7a.

If the diode 14' is healthy, then the DC input voltage Uᵢₙ will remain at the rated value while the DC output voltage U_{dout} increases. At a time t₃, DC output voltage U_{dout} surpasses the DC input voltage Uᵢₙ by the specific voltage difference U_{dif} and thereby a comparison of the two junction voltages U₁ and U₂ within the controller 40 produces the step function shown in Fig. 7b.

On the contrary, if the diode 14' is faulty, then current will flow through the diode 14' to equalize the DC output and input voltages Uᵢₙ and U_{dout}. Hence, the DC output voltage U_{dout} will not exceed the DC input voltage Uᵢₙ by the specific voltage difference U_{dif}. Accordingly the first junction voltage U₁ remains greater than the second junction voltage U₂ throughout the second test period ΔT₂ and no step function is generated from the comparison of the two junction voltages U₁ and U₂ and the controller 40 outputs an error signal DT_{Error} to the elevator controller 32 as shown in Fig. 7c.

Although not shown, it will be appreciated, that a further alternative to increase the DC output voltage U_{dout} from the diode 14' during the second period ΔT₂ of the test, would be to arrange a choke between the diode output and the supercapacitor, and a serial network of a transistor and a resistor between a voltage source which is positive with respect to the nominal voltage of the supercapacitor and the diode output. During the second test period ΔT₂, the transistor will close the serial network and the voltage at the output of the diode will increase.

Furthermore, the skilled person will immediately recognize that with some modification the resistor networks R1, R2, R3 and R4 together with the controller 40 can be used to substitute the second comparator 30 and controller 24 of the embodiment illustrated in Fig. 2.

Of course, there are many other arrangements available to temporarily reverse the polarity across the isolation means 14 and many alternative means of monitoring the DC input voltage Uᵢₙ during the second period ΔT₂ of the test cycle.

Although, the UPS 10 converts the AC from the mains supply 1 into usable DC for the brake modules 2, the skilled person will readily appreciate that with appropriate arrangements of AC/DC converters or DC/AC converters in the circuit, the UPS 10 can be powered from any power source AC or DC to provide a guaranteed power supply for any AC or DC application.

Furthermore, although the invention has been described with reference to a rechargeable power supply, and more particularly supercapacitors 16, it will be appreciated that alternative auxiliary power supplies, such as second commercial mains power supplies, fuel cells, back-up generators etc., can also be used.

## Claims

1. An uninterruptible power supply (10) comprising:
an input for coupling to a main power supply (1);
an output for connection to an electrical load (2);
a rechargeable energy storage unit (16) chargeable from the input; and
selective isolation means (14) configured to isolate the rechargeable energy storage unit (16) from the input during emergency operation **CHARACTERISED in** further comprising
first means (26,28,36,42) adapted to establish a reverse polarity across the isolation means (14) for a test period (ΔT₂) during normal operation; and
second means (30,24;R1,R2,R3,R4,40) adapted to monitor a voltage (Uᵢₙ;U₁) proportional to an input voltage (Uᵢₙ) to the isolation means (14) and adapted to output an error signal (DT_{Error}) if the monitored voltage (Uᵢₙ;U₁) remains or rises above a first reference value (U_{ref2};U₂) during the test period (ΔT₂).

2. An uninterruptible power supply (10) according to claim 1, wherein the first means comprises of a resistor (28) and a transistor (26) serially arranged between an input to the isolation means (14) and earth.

3. An uninterruptible power supply (10) according to claim 2 further comprising a capacitor connected in parallel across the resistor (28).

4. An uninterruptible power supply (10) according to claim 2 or claim 3 further comprising a choke (43) arranged between the input of the uninterruptible power supply (10) and the input to the isolation means (14).

5. An uninterruptible power supply (10) according to claim 1 further comprising a resistor (28) arranged between an input to the isolation means (14) and earth, and wherein the first means comprises a disconnection switch (36) at the main power supply (1) or arranged between the main power supply (1) and the isolation means (14).

6. An uninterruptible power supply (10) according to claim 1 or claim 2 further comprising a resistor (28) arranged between an input to the isolation means (14) and earth, and wherein the first means comprises a disconnection switch (36) at the main power supply (1) or arranged between the main power supply (1) and the isolation means (14).

7. An uninterruptible power supply (10) according to claim 1 or claim 2 further comprising a transformer (42) having a primary winding arranged between an output of the isolation means (14) and the auxiliary power supply (16), and wherein the first means comprises of a secondary winding of the transformer (42), a resistor (28) and a transistor (26) serially arranged between the auxiliary power supply (16) and earth.

8. An uninterruptible power supply (10) according to any preceding claim wherein the second means comprises a first comparator (30) to compare the input voltage (Uᵢₙ) to the isolation means (14) with the first reference value (U_{ref2}) and a controller (24) to monitor a output signal (DT_{Response}) from the comparator (30).

9. An uninterruptible power supply (10) according to any of claims 1 to 7, wherein the second means comprises a first resistor network (R1,R2) connected between an input to the isolation means (14) and earth to provide a first voltage (U₁) proportional to the input voltage (Uᵢₙ), a second resistor network (R3,R4) connected between an output of the isolation means (14) and earth to provide the first reference value (U₂) which is proportional to a voltage (U_{dout}) at the output of the isolation means (14), and a controller (40) comparing the first voltage (U₁) with the first reference value (U₂).

10. An uninterruptible power supply (10) according to any preceding claim further comprising a second comparator (22) comparing a voltage (Uₒᵤₜ) at the output of the uninterruptible power supply (10) with a second reference value (U_{ref1}) and outputting a test commence signal (SOF) if the output voltage (Uₒᵤₜ) is greater than the second reference value (U_{ref1}).

11. A method for testing selective isolation means (14) used in an uninterruptible power supply (10) to isolate an auxiliary power supply (16) from an input during emergency operation, **CHARACTERISED BY**:
establishing a reverse polarity across the isolation means (14) for a test period (ΔT₂) during normal operation;
monitoring a voltage (Uᵢₙ;U₁) proportional to an input voltage (Uᵢₙ) to the isolation means (14); and
outputting an error signal (DT_{Error}) if the monitored voltage (Uᵢₙ;U₁) remains or rises above a first reference value (U_{ref2}; U₂) during the test period (ΔT₂).

## Patentansprüche

1. Unterbrechungsfreie Stromversorgung (10), Folgendes umfassend:
einen Eingang zum Koppeln an eine Hauptstromversorgung (1);
einen Ausgang zum Anschließen einer elektrischen Last (2);
eine wiederaufladbare Energiespeichereinheit (16), die über den Eingang aufladbar ist; und
selektive Isoliermittel (14), die dazu geeignet sind, die wiederaufladbare Energiespeichereinheit (16) während des Notbetriebs von dem Eingang zu isolieren, **dadurch GEKENNZEICHNET, dass** ferner umfasst sind,
erste Mittel (26, 28, 36, 42), die eingerichtet sind, während des normalen Betriebs während eines Testzeitraums (ΔT₂) an den Isoliermitteln (14) eine umgekehrte Polarität herbeizuführen; und
zweite Mittel (30, 24; R1, R2, R3, R4, 40), die dazu eingerichtet sind, eine zu einer Eingangsspannung (Uᵢₙ) proportionale Spannung (Uᵢₙ; U₁) an den Isoliermitteln (14) zu überwachen, und dazu eingerichtet sind, ein Fehlersignal (DT_{Error}) auszugeben, wenn die überwachte Spannung (Uᵢₙ; U₁) während des Testzeitraums (ΔT₂) über einem ersten Referenzwert (U_{ref2}; U₂) bleibt oder über diesen ansteigt.

2. Unterbrechungsfreie Stromversorgung (10) nach Anspruch 1, wobei die ersten Mittel einen Widerstand (28) und einen Transistor (26) umfassen, die zwischen einem Eingang der Isoliermittel (14) und Erde in Reihe angeordnet sind.

3. Unterbrechungsfreie Stromversorgung (10) nach Anspruch 2, weiterhin einen Kondensator umfassend, der parallel zu dem Widerstand (28) geschaltet ist.

4. Unterbrechungsfreie Stromversorgung (10) nach Anspruch 2 oder 3, ferner eine Drosselspule (43) umfassend, die zwischen dem Eingang der unterbrechungsfreien Stromversorgung (10) und dem Eingang der Isoliermittel (14) angeordnet ist.

5. Unterbrechungsfreie Stromversorgung (10) nach Anspruch 1, ferner einen Widerstand (28) umfassend, der zwischen einem Eingang der Isoliermittel (14) und Erde angeordnet ist, und wobei die ersten Mittel an der Hauptstromversorgung (1) oder zwischen der Hauptstromversorgung (1) und den Isoliermitteln (14) angeordnet einen Trennschalter (36) umfassen.

6. Unterbrechungsfreie Stromversorgung (10) nach Anspruch 1 oder 2, ferner einen Widerstand (28) umfassend, der zwischen einem Eingang der Isoliermittel (14) und Erde angeordnet ist, und wobei die ersten Mittel an der Hauptstromversorgung (1) oder zwischen der Hauptstromversorgung (1) und den Isoliermitteln (14) angeordnet einen Trennschalter (36) umfassen.

7. Unterbrechungsfreie Stromversorgung (10) nach Anspruch 1 oder Anspruch 2, ferner einen Transformator (42) mit einer Primärwicklung umfassend, der zwischen einem Ausgang der Isoliermittel (14) und der Hilfsstromversorgung (16) angeordnet ist, und wobei die ersten Mittel eine Sekundärwicklung des Transformators (42), einen Widerstand (28) und einen Transistor (26) umfassen, die zwischen der Hilfsstromversorgung (16) und Erde in Reihe angeordnet sind.

8. Unterbrechungsfreie Stromversorgung (10) nach einem der vorhergehenden Ansprüche, wobei die zweiten Mittel zum Vergleichen der Eingangsspannung (Uᵢₙ) an den Isoliermitteln (14) mit dem ersten Referenzwert (U_{ref2}) einen ersten Komparator (30) und zum Überwachen eines Ausgangssignals (DT_{Response}) des Komparators (30) eine Steuerung (24) aufweisen.

9. Unterbrechungsfreie Stromversorgung (10) nach einem der Ansprüche 1 bis 7, wobei die zweiten Mittel zum Bereitstellen einer zur Eingangsspannung (Uᵢₙ) proportionalen ersten Spannung (U₁) ein zwischen einem Eingang der Isoliermittel (14) und Erde geschaltetes erstes Widerstandsnetzwerk (R1, R2), zum Bereitstellen des zu einer Spannung (U_{dout}) am Ausgang der Isolationsmittel (14) proportionalen ersten Referenzwerts (U₂) ein zwischen einem Ausgang der Isolationsmittel (14) und Erde geschaltetes zweites Widerstandsnetzwerk (R3, R4) und eine Steuerung (40) umfassen, die die erste Spannung (U₁) mit dem ersten Referenzwert (U₂) vergleicht.

10. Unterbrechungsfreie Stromversorgung (10) nach einem vorhergehenden Anspruch, ferner einen zweiten Komparator (22) umfassend, der eine Spannung (Uₒᵤₜ) am Ausgang der unterbrechungsfreien Stromversorgung (10) mit einem zweiten Referenzwert (U_{ref1}) vergleicht und ein Teststartsignal (SOF) ausgibt, wenn die Ausgangsspannung (Uₒᵤₜ) größer als der zweite Referenzwert (U_{ref1}) ist.

11. Verfahren zum Testen von in einer unterbrechungsfreien Stromversorgung (10) verwendenden selektiven Isoliermitteln (14), um während des Notbetriebs eine Hilfsstromversorgung (16) von einem Eingang zu isolieren, durch Folgendes GEKENNZEICHNET:
Herbeiführen einer umgekehrten Polarität an den Isoliermitteln (14) während eines Testzeitraums (ΔT₂) während des normalen Betriebs;
Überwachen einer zu einer Eingangsspannung (Uᵢₙ) an den Isoliermitteln (14) proportionalen Spannung (Uᵢₙ; U₁); und
Ausgeben eines Fehlersignals (DT_{Error}), wenn die überwachte Spannung (Dᵢₙ; U₁) während des Testzeitraums (ΔT₂) über einem ersten Referenzwert (U_{ref2}; U₂) bleibt oder über diesen ansteigt.

## Revendications

1. Alimentation sans coupure (10), comprenant :
une entrée pour le couplage à une alimentation principale (1) ;
une sortie pour la connexion à une charge électrique (2) ;
un accumulateur d'énergie rechargeable (16) pouvant être chargé à partir de l'entrée ; et
un moyen d'isolation sélective (14) configuré pour isoler l'accumulateur d'énergie rechargeable (16) de l'entrée en mode d'urgence, **CARACTÉRISÉE en ce qu'**elle comprend en outre un premier moyen (26, 28, 36, 42) conçu pour établir une polarité inversée à travers le moyen d'isolation (14) pendant une période de test (ΔT₂) en fonctionnement normal ; et
un second moyen (30, 24 ; R1, R2, R3, R4, 40) conçu pour surveiller une tension (Uᵢₙ ; U₁) proportionnelle à une tension d'entrée (Uᵢₙ) du moyen d'isolation (14), et conçu pour émettre un signal d'erreur (DT_{Error}) si la tension surveillée (Uᵢₙ ; U₁) reste ou s'élève au-dessus d'une première valeur de référence (U_{ref2} ; U₂) pendant la période de test (ΔT₂).

2. Alimentation sans coupure (10) selon la revendication 1, dans laquelle le premier moyen comprend une résistance (28) et un transistor (26) disposés en série entre une entrée du moyen d'isolation (14) et la masse.

3. Alimentation sans coupure (10) selon la revendication 2, comprenant en outre un condensateur connecté en parallèle aux bornes de la résistance (28).

4. Alimentation sans coupure (10) selon la revendication 2 ou 3, comprenant en outre une bobine d'arrêt (43) placée entre l'entrée de l'alimentation sans coupure (10) et l'entrée du moyen d'isolation (14).

5. Alimentation sans coupure (10) selon la revendication 1, comprenant en outre une résistance (28) disposée entre une entrée du moyen d'isolation (14) et la masse, et dans laquelle le premier moyen comprend un disjoncteur (36) au niveau de l'alimentation principale (1) ou est disposé entre l'alimentation principale (1) et le moyen d'isolation (14).

6. Alimentation sans coupure (10) selon la revendication 1 ou 2, comprenant en outre une résistance (28) disposée entre une entrée du moyen d'isolation (14) et la masse, et dans laquelle le premier moyen comprend un disjoncteur (36) au niveau de l'alimentation principale (1) ou est disposé entre l'alimentation principale (1) et le moyen d'isolation (14).

7. Alimentation sans coupure (10) selon la revendication 1 ou 2, comprenant en outre un transformateur (42) comportant un enroulement primaire disposé entre une sortie du moyen d'isolation (14) et l'alimentation auxiliaire (16), et dans laquelle le premier moyen comprend un enroulement secondaire du transformateur (42), une résistance (28) et un transistor (26) disposés en série entre l'alimentation auxiliaire (16) et la masse.

8. Alimentation sans coupure (10) selon l'une des revendications précédentes, dans laquelle le second moyen comprend un premier comparateur (30) pour comparer la tension d'entrée (Uᵢₙ) du moyen d'isolation (14) à la première valeur de référence (U_{ref2}) et un contrôleur (24) pour surveiller un signal de sortie (DT_{Response}) provenant du comparateur (30).

9. Alimentation sans coupure (10) selon l'une des revendications 1 à 7, dans laquelle le second moyen comprend un premier réseau de résistances (R1, R2) connecté entre une entrée du moyen d'isolation (14) et la masse de façon à produire une première tension (U₁) proportionnelle à la tension d'entrée (Uᵢₙ), un second réseau de résistances (R3, R4) connecté entre une sortie du moyen d'isolation (14) et la masse de façon à produire la première valeur de référence (U₂) proportionnelle à une tension (U_{dout}) à la sortie du moyen d'isolation (14), et un contrôleur (40) comparant la première tension (U₁) à la première valeur de référence (U₂).

10. Alimentation sans coupure (10) selon l'une des revendications précédentes, comprenant en outre un second comparateur (22) comparant une tension (Uₒᵤₜ) à la sortie de l'alimentation sans coupure (10) à une seconde valeur de référence (U_{ref1}), et émettant un signal de début de test (SOF) si la tension de sortie (Uₒᵤₜ) est supérieure à la seconde valeur de référence (U_{ref1}).

11. Procédé de test d'un moyen d'isolation sélective (14) utilisé dans une alimentation sans coupure (10) pour isoler une alimentation auxiliaire (16) d'une entrée en mode d'urgence, **CARACTÉRISÉ PAR** :
l'établissement d'une polarité inversée à travers le moyen d'isolation (14) pendant une période de test (ΔT₂) en fonctionnement normal ;
la surveillance d'une tension (Uᵢₙ ; U₁) proportionnelle à une tension d'entrée (Uₙ) du moyen d'isolation (14) ; et
l'émission d'un signal d'erreur (DT_{Error}) si la tension surveillée (Uᵢₙ ; U₁) reste ou s'élève au-dessus d'une première valeur de référence (U_{ref2} ; U₂) pendant la période de test (ΔT₂).
